# EUROPÄISCHE PATENTSCHRIFT

(11) **EP 3 488 190 B1**
(45) Veröffentlichungstag und Bekanntmachung des Hinweises auf die Patenterteilung: **15.12.2021**
(21) Anmeldenummer: 16750611.2
(22) Anmeldetag: 22.07.2016
(51) Int. Cl.: G01D 5/347, H01H 19/14, H03K 17/968, G06F 3/0362, G06F 3/038

(54) **DREHBETÄTIGUNGSVORRICHTUNG**
ROTATING ACTUATION DEVICE
DISPOSITIF D'ACTIONNEMENT ROTATIF

(43) Veröffentlichungstag der Anmeldung: 29.05.2019
(60) Teilanmeldung: 21178480.6
(73) Patentinhaber: Diehl AKO Stiftung & Co. KG, 88239 Wangen (DE)
(72) Erfinder: MAIGLER, Andreas, 88339 Bad Waldsee (DE); FUHGE, Bruno, 88147 Achberg (DE)
(74) Vertreter: Diehl Patentabteilung
(86) Internationale Anmeldenummer: PCT/EP2016/001279
(87) Internationale Veröffentlichungsnummer: WO 2018/014926

(56) Entgegenhaltungen:
- EP-A1- 2 860 459
- EP-A2- 1 150 242
- DE-B3-102004 013 947
- DE-B3-102007 016 466

## Beschreibung

### Drehbetätigungsvorrichtu ng

Die vorliegende Erfindung betrifft eine Drehbetätigungsvorrichtung, insbesondere eine Drehbetätigungsvorrichtung zur Verwendung in einer Bedienvorrichtung eines elektronischen Haushaltsgeräts.

Bei elektronischen Haushaltsgeräten werden in den Bedienvorrichtungen häufig Drehbetätigungsvorrichtungen eingesetzt, mit denen ein Benutzer durch Drehen eines Betätigungsknopfes einen gewünschten Wert eines Parameters wie beispielsweise einer Kochstufe, einer Kochzeit und dergleichen einstellen kann. Zum Erfassen einer Drehbetätigung des Betätigungsknopfes sind zum Beispiel resistive, elektrische und kapazitive Technologien bekannt.

Die DE 10 2007 016 466 B3 offenbart eine Bedienungseinrichtung für ein Kochfeld mit einem drehbar gelagerten Dreh-Bedienteil, wobei das Dreh-Bedienteil in einem Ausführungsbeispiel ein exzentrisches Drehteil aufweist, neben dem ein optischer Abstandssensor zum Bestimmen der Dreh- oder Winkelposition des Dreh-Bedienteils angeordnet ist, und in einem anderen Ausführungsbeispiel ein Drehteil mit einer optischen Codierung zum Erkennen der Drehposition an seiner Unterseite aufweist, die durch einen optischen Sensor erkennbar ist.

Die DE 10 2004 013 947 B3 offenbart eine Bedienvorrichtung für ein Glaskeramickochfeld in der Form eines Drehknebels, bei der an der Unterseite des Drehknebels ein Messstreifen vorgesehen ist, der auf einer Kreisbahn angeordnet ist und entlang der Kreisbahn kontinuierlich oder stufenweise verändernde physikalische Eigenschaften aufweist, und bei der ein Sensor entsprechend der Kreisbahn des Messstreifens vorgesehen ist, der die physikalische Eigenschaft des dem Sensor gegenüberliegenden Abschnitts des Messstreifens erfasst, um eine Drehposition des Drehknebels zu erkennen. Im Fall eines optischen Sensors hat der Messstreifen eine sich in Graustufen von Weiß bis Schwarz ändernde Reflektivität, und im Fall eines kapazitiven Sensors hat der Messstreifen eine um die Kreisbahn zu-oder abnehmenden Abstand zum Sensor.

Der Erfindung liegt die Aufgabe zugrunde, eine verbesserte Drehbetätigungsvorrichtung mit einfachem Aufbau und zuverlässiger Funktionsweise bereitzustellen.

Diese Aufgabe wird gelöst durch eine Drehbetätigungsvorrichtung mit den Merkmalen des Anspruchs 1. Besonders bevorzugte Ausgestaltungen und Weiterbildungen der Erfindung sind Gegenstand der abhängigen Ansprüche.

Die Drehbetätigungsvorrichtung der Erfindung weist einen um eine Drehachse drehbar gelagerten Betätigungsknopf und eine Erfassungseinrichtung zum Erfassen einer Drehbetätigung des Betätigungsknopfes auf. Der Betätigungsknopf hat an einer Stirnseite des Betätigungsknopfes einen Reflexionsabschnitt, der Reflexionsflächen mit entlang einer Umfangsrichtung des Betätigungsknopfes unterschiedlichen Reflexionspositionen aufweist. Die Erfassungseinrichtung weist wenigstens einen ortsfesten optischen Abstandssensor, der in axialer Richtung des Betätigungsknopfes der Stirnseite gegenüberliegend angeordnet ist, zum Erfassen eines Abstandes zwischen dem Abstandssensor und einer dem Abstandssensor aktuell zugewandten Reflexionsfläche des Reflexionsabschnitts des Betätigungsknopfes auf.

Für die Erfassung einer Drehbetätigung des Betätigungsknopfes genügen bei der Drehbetätigungsvorrichtung der Erfindung Reflexionsflächen am Betätigungsknopf und wenigstens ein diesen zugeordneter optischer Abstandssensor. Die Drehbetätigungsvorrichtung kann daher mit wenigen Bauteilen einfach realisiert werden. Außerdem ermöglicht die Erfassung der Drehbetätigung mittels optischer Abstandssensoren eine sehr zuverlässige Funktionsweise über eine lange Einsatzdauer der Drehbetätigungsvorrichtung hinweg. Vorzugsweise ist bei diesem Aufbau der Drehbetätigungsvorrichtung auch ein Selbstkalibrieren der Erfassungseinrichtung möglich.

Unter einem Erfassen einer Drehbetätigung des Betätigungsknopfes sollen in diesem Zusammenhang insbesondere das Erfassen absoluter Drehstellungen, relativer Drehstellungen, Drehrichtungen, Drehgeschwindigkeiten und Kombinationen dieser Parameter verstanden werden.

Ein optischer Abstandssensor weist wenigstens einen optischen Sender zum Emittieren elektromagnetischer Strahlung (bevorzugt im sichtbaren oder Infrarot-Wellenlängenbereich) und wenigstens einen optischen Empfänger zum Detektieren elektromagnetischer Strahlung desselben Wellenlängenbereichs auf. Der optische Abstandssensor ist zudem durch seine Ausgestaltung und/oder Anordnung in der Lage, aus der detektierten elektromagnetischen Strahlung einen Abstand zwischen dem Abstandssensor und dem Reflexionsort der elektromagnetischen Strahlung zu bestimmen. Dies kann vorzugsweise anhand einer Intensität, eines Detektionsortes und/oder eines Detektionszeitpunktes der am Empfänger detektierten Strahlung erfolgen.

Reflexionsflächen sind in diesem Zusammenhang Flächen, die in der Lage sind, die von dem Sender des optischen Abstandssensors emittierte elektromagnetische Strahlung in einem Maße zu reflektieren, das für die Detektion durch den Empfänger des optischen Abstandssensors ausreicht. Das Reflexionsvermögen der Reflexionsflächen beträgt vorzugsweise wenigstens etwa 50%, bevorzugter wenigstens etwa 75% bezogen auf die von dem wenigstens einen optischen Abstandssensor verwendete elektromagnetische Strahlung.

Die Reflexionspositionen der Reflexionsflächen verändern sich entlang der Umfangsrichtung des Betätigungsknopfes vorzugsweise kontinuierlich oder stufenweise. Die Veränderung kann dabei stetig (d.h. zum Beispiel mit kontinuierlich größer werdendem Abstand) oder unstetig (d.h. zum Beispiel Stufen mit abwechselnd oder gemischt größer und kleiner werdenden Abständen) ausgestaltet sein.

Die Reflexionsflächen des Reflexionsabschnitts erstrecken sich entsprechend des möglichen Drehweges des Betätigungsknopfes insgesamt bevorzugt über die gesamte Umfangslänge des Betätigungsknopfes oder über einen Teil der Umfangslänge (z.B. 50%, 75%, etc.) des Betätigungsknopfes.

In einer bevorzugten Ausgestaltung der Erfindung weist der Reflexionsabschnitt des Betätigungsknopfes wenigstens zwei koaxial zueinander angeordnete Teilabschnitte mit unterschiedlichen Reflexionseigenschaften (insbesondere unterschiedlichen Reflexionspositionen und/oder unterschiedlichen Reflexionsgraden) auf. Die Erfassungseinrichtung weist bei dieser Ausgestaltung vorzugsweise wenigstens zwei in radialer Richtung des Betätigungsknopfes nebeneinander angeordnete optische Abstandssensoren auf. Die Zuverlässigkeit der Funktionsweise der Drehbetätigungsvorrichtung kann so zum Beispiel durch eine Differenzwertauswertung der wenigstens zwei Abstandssensoren verbessert werden.

In einer weiteren bevorzugten Ausgestaltung der Erfindung weist die Erfassungseinrichtung wenigstens zwei optische Abstandssensoren mit einem gemeinsamen Sender auf. Durch die gemeinsame Nutzung eines Senders können die optischen Abstandssensoren insgesamt einfacher und kostengünstiger gefertigt werden.

In einer weiteren bevorzugten Ausgestaltung der Erfindung ist der Betätigungsknopf außerdem in einer axialen Richtung bewegbar gelagert. Durch die Möglichkeit auch einer axialen Bewegung des Betätigungsknopfes kann zum Beispiel mittels Drehen des Betätigungsknopfes ein Parameterwert verändert werden und dann mittels Drücken des Betätigungsknopfes der ausgewählte Parameterwert bestätigt werden.

Eine axiale Bewegung des Betätigungsknopfes kann vorzugsweise mit den bereits vorhandenen optischen Abstandssensoren detektiert werden, indem ein sich noch weiter verändernder, insbesondere verringernder Abstand zwischen den Reflexionsflächen und den Abstandssensoren erfasst und ausgewertet wird.

Bei der Ausgestaltung des Betätigungsknopfes mit Reflexionsflächen an dessen Stirnseite sind für ein solches Detektieren der axialen Bewegung keine weiteren Maßnahmen erforderlich. Es genügt eine entsprechende Auswertung der Messsignale der optischen Abstandssensoren, die der Stirnseite des Betätigungsknopfes gegenüberliegend angeordnet sind.

In einer noch weiteren Ausgestaltung der Erfindung weist die Drehbetätigungsvorrichtung ferner eine Bedienblende auf, an welcher der Betätigungsknopf gelagert ist.

Bei dieser Ausgestaltung weist die Drehbetätigungsvorrichtung vorzugsweise ferner eine Haltevorrichtung zum Halten des Betätigungsknopfes an der Bedienblende auf. Das Halten umfasst in diesem Zusammenhang bevorzugt eine positionsfeste Lagerung und Führung des Betätigungsknopfes.

Falls der Betätigungsknopf auch in axialer Richtung bewegbar gelagert ist, spannt diese Haltevorrichtung den Betätigungsknopf vorzugsweise in axialer Richtung in eine axiale Ruhestellung vor.

In einer noch weiteren Ausgestaltung der Erfindung weist die Drehbetätigungsvorrichtung ferner eine Rasteinrichtung zum Verrasten des Betätigungsknopfes in mehreren vorgegebenen Drehstellungen auf. Durch diese Rasteinrichtung kann der Benutzer der Drehbetätigungsvorrichtung vorzugsweise ein haptisches Feedback über die von ihm vorgenommene Drehbetätigung bekommen. Außerdem kann durch diese Rasteinrichtung der Betätigungsknopf vorzugsweise in vorgegebene Drehstellungen bewegt werden, sodass die Erfassung der Drehbetätigung durch die optischen Abstandssensoren einfacher und zuverlässiger erfolgen kann.

In einer noch weiteren bevorzugten Ausgestaltung der Erfindung weist die Drehbetätigungsvorrichtung ferner wenigstens eine optische Anzeigevorrichtung auf. Dabei ist der Betätigungsknopf bevorzugt relativ zu der wenigstens einen Anzeigevorrichtung bewegbar, d.h. die Anzeigevorrichtung ist drehfest installiert und bleibt auch bei einer Drehbetätigung des Betätigungsknopfes für den Benutzer in einer gleichbleibenden lesbaren Orientierung.

Bei der erfindungsgemäßen Drehbetätigungsvorrichtung ist der Reflexionsabschnitt des Betätigungsknopfes vorzugsweise auf einer einem Benutzer der Drehbetätigungsvorrichtung abgewandten Rückseite der Bedienblende positioniert. D.h. die Bedienblende weist eine Durchbrechung auf, durch welche der Betätigungsknopf hindurchgeführt ist. In alternativen Ausführungsformen der Erfindung kann der Reflexionsabschnitt des Betätigungsknopfes auch auf einer dem Benutzer zugewandten Außenseite der dann vorzugsweise wenigstens teiltransparenten Bedienblende angeordnet sein.

Gegenstand der Erfindung ist auch ein elektronisches Haushaltsgerät mit wenigstens einer oben beschriebenen Drehbetätigungsvorrichtung der Erfindung. Bei dem elektronischen Haushaltsgerät handelt es sich zum Beispiel um ein Kochfeld, einen Herd, einen Mikrowellenofen, einen Geschirrspüler, ein Wäschebehandlungsgerät oder dergleichen.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:
- Fig. 1: eine seitliche Perspektivansicht einer Drehbetätigungsvorrichtung gemäß einem Ausführungsbeispiel der Erfindung;
- Fig. 2: eine weitere Perspektivansicht der Drehbetätigungsvorrichtung von Fig. 1 ohne Trägerplatte;
- Fig. 3: Diagramme zur Veranschaulichung einer möglichen Auswertung der Messsignale von zwei optischen Abstandssensoren; und
- Fig. 4: ein Diagramm zur Veranschaulichung einer möglichen Auswertung der Messsignale eines einzelnen optischen Abstandssensors.

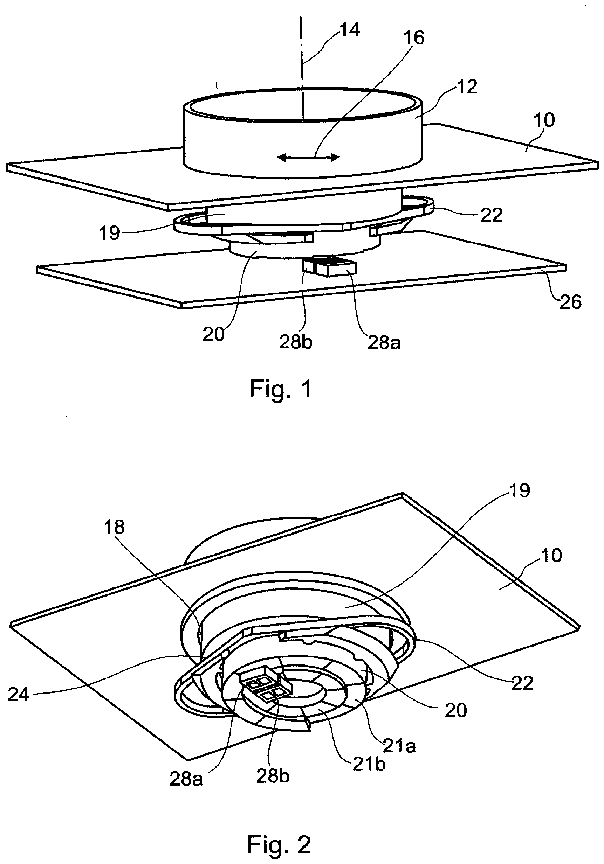

Bezug nehmend auf Fig. 1 und 2 wird zunächst der Aufbau einer Drehbetätigungsvorrichtung gemäß einem Ausführungsbeispiel näher beschrieben.

Die Drehbetätigungsvorrichtung weist einen Betätigungsknopf 12 in Form eines Drehknebels auf, der drehbar an einer Bedienblende 10 zum Beispiel eines elektronischen Haushaltsgeräts gelagert ist. Die Bedienblende 10 ist zum Beispiel eine Kunststoffplatte oder eine Glaskeramikplatte. Der Betätigungsknopf 12 ist um eine Drehachse 14, die einer Längsachse bzw. einer axialen Richtung des Betätigungsknopfes 12 entspricht, in einer Drehrichtung 16, die einer Umfangsrichtung des Betätigungsknopfes 12 entspricht, drehbar. Dabei kann der Betätigungsknopf 12 um eine volle Umdrehung (360°), über eine volle Umdrehung hinaus fortlaufend oder nur um eine Teildrehung (z.B. 180°, 270°, etc.) drehbar sein.

Der Betätigungsknopf 12 ist durch eine Durchbrechung 18 in der Bedienblende 10 hindurch geführt. Zur besseren Führung und Halterung des Betätigungsknopfes 12 kann die Durchbrechung 18 optional mit einem Flansch 19 versehen sein. Ein Bedienabschnitt des Betätigungsknopfes 12 ist auf einer dem Benutzer zugewandten Außenseite der Bedienblende 10 (oben in Fig. 1 und 2) positioniert, sodass er von dem Benutzer gegriffen werden kann.

Der Betätigungsknopf 12 ist an der Bedienblende 10 mittels einer Haltevorrichtung 22 in Form einer Feder gehalten. Diese Haltevorrichtung 22 ist in einer Haltenut 24 des Flansches 19 geführt und steht mit dem Betätigungsknopf 12 in Eingriff. Optional kann diese Haltevorrichtung 22 auch die Funktion einer Rastvorrichtung übernehmen, sodass der Betätigungsknopf 12 in mehreren vorgegebenen Drehstellungen verrasten kann. Die Feder greift hierzu in bzw. an die Umfangsseite des Betätigungsknopfes 12 elastisch ein und die Umfangsseite des Betätigungsknopfes 12 weist hierzu bevorzugt Rastvorsprünge oder Rastvertiefungen in vorbestimmten Winkelpositionen auf.

Auf der dem Benutzer abgewandten Rückseite der Bedienblende 10 (unten in Fig. 1 und 2) weist der Betätigungsknopf 12 einen Reflexionsabschnitt 20 auf. Dieser Reflexionsabschnitt 20 weist an der der Bedienblende 10 abgewandten Stirnseite des Betätigungsknopfes 12 mehrere Reflexionsflächen auf. In dem Ausführungsbeispiel von Fig. 1 und 2 weist der Reflexionsabschnitt 20 zwei Teilabschnitte 21a, 21b auf, die koaxial zueinander an der Stirnseite des Betätigungsknopfes 12 vorgesehen sind und jeweils mehrere Reflexionsflächen aufweisen.

Auf der dem Benutzer abgewandten Rückseite der Bedienblende 10 ist zudem im Wesentlichen parallel zu dieser eine Trägerplatte 26 angeordnet. Auf dieser Trägerplatte 26 ist wenigstens ein optischer Abstandssensor 28a, 28b montiert, der mit einer Auswerteschaltung (nicht dargestellt) verbunden ist. Diese Auswerteschaltung kann ebenfalls auf der Trägerplatte 26 oder an einem anderen Ort vorgesehen sein. In dem Ausführungsbeispiel von Fig. 1 und 2 weist die Drehbetätigungsvorrichtung bzw. ihre Erfassungseinrichtung zwei optische Abstandssensoren 28a, 28b auf, die in radialer Richtung senkrecht zur Drehachse 14 des Betätigungsknopfes 12 nebeneinander ortsfest auf der Trägerplatte 26 angebracht sind.

Die zwei optischen Abstandssensoren 28a, 28b weisen jeweils wenigstens einen Sender zum Emittieren elektromagnetischer Strahlung zum Beispiel im sichtbaren oder Infrarot-Wellenlängenbereich in Richtung zum Betätigungsknopf 12 und wenigstens einen Empfänger zum Erfassen elektromagnetischer Strahlung desselben Wellenlängenbereichs auf. Alternativ können die beiden optischen Abstandssensoren auch wenigstens einen gemeinsamen Sender aufweisen.

Wie in Fig. 2 erkennbar, weisen die beiden Teilabschnitte 21a, 21b des Reflexionsabschnitts 20 entlang der Umfangsrichtung 16 des Betätigungsknopfes 12 jeweils mehrere Reflexionsflächen mit unterschiedlichen Höhen auf, wobei auch die Höhen der Reflexionsflächen der zwei Teilabschnitte 21a, 21b unterschiedlich zueinander sind. Die Reflexionsflächen der Teilabschnitte 21a, 21b können als Stufen oder schiefe Ebenen ausgestaltet sein. Die Variation der Stufenhöhen ist in diesem Ausführungsbeispiel unstetig.

Die Reflexionsflächen haben jeweils einen Reflexionsgrad von zum Beispiel wenigstens etwa 50% bezogen auf die von den Sendern der Abstandssensoren 28a, 28b emittierte Strahlung. Dieser Reflexionsgrad kann durch eine Materialauswahl, eine Oberflächenbeschaffenheit und/oder eine Beschichtung der Reflexionsflächen erzielt werden.

Der erste Abstandssensor 28a ist dem ersten Teilabschnitt 21a gegenüberliegend positioniert, und der zweite Abstandssensor 28b ist dem zweiten Teilabschnitt 21b gegenüberliegend positioniert. Die beiden Abstandssensoren 28a, 28b sind derart ausgestaltet und angeordnet, dass aus der detektierten elektromagnetischen Strahlung ein Abstand zwischen dem jeweiligen Abstandssensor 28a, 28b und der diesem gegenüberliegenden Reflexionsfläche des ersten Teilabschnitts 21a bzw. zweiten Teilabschnitts 21b bestimmt werden kann. Hierzu können beispielsweise die Intensität, der Detektionsort und/oder der Detektionszeitpunkt der von den Empfängern erfassten elektromagnetischen Strahlung ausgewertet werden.

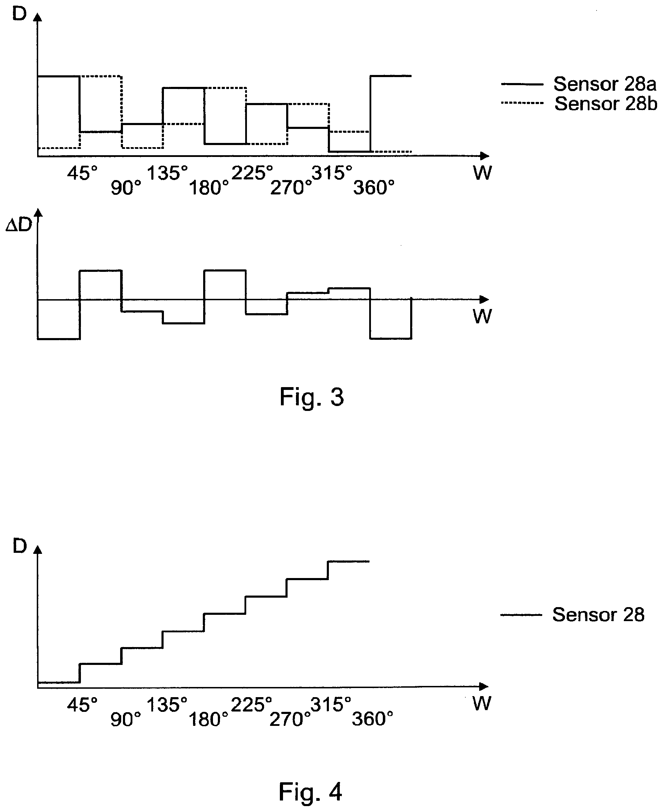

Eine Möglichkeit der Auswertung der Messsignale der beiden Abstandssensoren 28a, 28b zeigt Fig. 3.

In dem gezeigten Ausführungsbeispiel haben der erste und der zweite Teilabschnitt 21a, 21b des Reflexionsabschnitts 20 jeweils acht Reflexionsflächen entlang der Umfangsrichtung 16 mit stufenweise unterschiedlichen Höhen bzw. Abständen zur Trägerplatte 26. Im oberen Diagramm von Fig. 3 sind die von den beiden Abstandssensoren 28a, 28b zu erfassenden Abstände D zu den Reflexionsflächen der beiden Teilabschnitte 21a bzw. 21b über dem Drehwinkel W des Betätigungsknopfes 12 aufgetragen. Durch die spezielle Auswahl der Höhen der Reflexionsflächen kann in diesem Ausführungsbeispiel vorzugsweise ein Differenzwertverfahren eingesetzt werden, bei welchem die Differenz ΔD zwischen den von den beiden Abstandssensoren 28a, 28b ermittelten Abständen D ermittelt wird, wie in dem unteren Diagramm von Fig. 3 veranschaulicht. Durch dieses Differenzwertverfahren kann in vorteilhafter Weise die absolute Drehstellung bzw. Winkelposition des Betätigungsknopfes 12 bestimmt werden. Außerdem kann sich die Erfassungseinrichtung mit den beiden Abstandssensoren 28a, 28b so selbst kalibrieren.

Sind in einer alternativen Ausführungsform der Erfindung zum Beispiel nur der erste Teilabschnitt 21a und der erste Abstandssensor 28a vorhanden, so kann zumindest die relative Drehstellung bzw. Winkelposition des Betätigungsknopfes bestimmt werden.

Außerdem können in beiden vorgenannten Ausführungsformen zudem Drehrichtung und Drehgeschwindigkeit ermittelt werden, falls erforderlich.

Um ein Umschalten zwischen zwei Drehstellungen des Betätigungsknopfes 12 sicher erkennen zu können, können die Stufen der Reflexionsflächen des ersten und des zweiten Teilabschnitts 21a, 21b in Umfangsrichtung 16 zueinander versetzt sein. Erst wenn zum Beispiel beide Abstandssensoren 28a, 28b eine Veränderung des Abstandswertes D erfasst haben, wird von der Auswerteschaltung auf eine Drehung des Betätigungsknopfes 12 zur nächsten Drehstellung geschlossen.

Wie in dem Diagramm von Fig. 4 veranschaulicht, kann in einer anderen Ausführungsform der Erfindung auch mit nur einem Abstandssensor 28 eine absolute Drehstellung bzw. Winkelposition des Betätigungsknopfes ermittelt werden, falls die Höhen der Reflexionsflächen entsprechend gewählt sind und der Abstandssensor 28 kalibriert ist. In diesem Zusammenhang kann vorzugsweise ein Schwellwertverfahren eingesetzt werden.

In einer Modifikation der oben beschriebenen Ausführungsformen kann der Betätigungsknopf 12 zudem in axialer Richtung bewegbar an der Bedienblende 10 gelagert sein. D.h. der Betätigungsknopf 12 kann durch den Benutzer nicht nur gedreht sondern auch gedrückt werden. Durch das Drücken des Betätigungsknopfes 12 kann zum Beispiel ein zuvor durch Drehen des Betätigungsknopfes 12 ausgewählter Parameterwert bestätigt und eingegeben werden.

Die als Feder ausgeführte Haltevorrichtung 22 spannt in diesem Fall vorzugsweise den Betätigungsknopf 12 in Richtung zum Benutzer hin in seine axiale Ruhestellung vor.

Beim Drücken des Betätigungsknopfes 12 in die Bedienblende 10 werden die von den Abstandssensoren 28a, 28b (oder von dem einen Abstandssensor 28) erfassten Abstände zu den Reflexionsflächen gleichzeitig entsprechend verringert. Dies kann von der Auswerteschaltung ausgewertet werden, um ein Drücken des Betätigungsknopfes zu detektieren. Für diese zusätzliche Funktionalität sind somit keine zusätzlichen Bauteile erforderlich.

Obwohl nicht dargestellt, weist die Drehbetätigungsvorrichtung zudem optional eine optische Anzeigevorrichtung auf. Die Anzeigevorrichtung zeigt dem Benutzer zum Beispiel den durch die Drehbewegung des Betätigungsknopfes 12 aktuell ausgewählten Parameterwert an. Diese Anzeigevorrichtung ist vorzugsweise in den Betätigungsknopf 12 integriert bzw. innerhalb des Betätigungsknopfes 12 angeordnet. Die Anzeigevorrichtung ist außerdem vorzugsweise ortsfest angebracht, sodass sie sich bei einer Drehbewegung des Betätigungsknopfes 12 nicht mit diesem mitdreht. Zum Beispiel kann die Anzeigevorrichtung in einer zentralen Durchbrechung im Betätigungsknopf 12 positioniert und auf der Trägerplatte 26 befestigt sein. Die Anzeigevorrichtung weist beispielsweise ein Display und/oder ein oder mehrere Leuchtdioden und/oder Lichtleitelemente auf.

### BEZUGSZIFFERNLISTE

- 10: Bedienblende
- 12: Betätigungsknopf, insbesondere Drehknebel
- 14: Drehachse
- 16: Umfangsrichtung
- 18: Durchbrechung
- 19: Flansch
- 20: Reflexionsabschnitt
- 21a: erster Teilabschnitt
- 21b: zweiter Teilabschnitt
- 22: Haltevorrichtung
- 24: Haltenut
- 26: Trägerplatte
- 28a: erster Abstandssensor
- 28b: zweiter Abstandssensor

## Patentansprüche

1. Drehbetätigungsvorrichtung, aufweisend:
einen um eine Drehachse (14) drehbar gelagerten Betätigungsknopf (12); und
eine Erfassungseinrichtung zum Erfassen einer Drehbetätigung des Betätigungsknopfes (12),
**dadurch gekennzeichnet, dass**
der Betätigungsknopf (12) an einer Stirnseite des Betätigungsknopfes (12) einen Reflexionsabschnitt (20) aufweist, der Reflexionsflächen mit entlang einer Umfangsrichtung (16) des Betätigungsknopfes (12) unterschiedlichen Reflexionspositionen aufweist; und
die Erfassungseinrichtung wenigstens einen ortsfesten optischen Abstandssensor (28a, 28b), der in axialer Richtung des Betätigungsknopfes der Stirnseite gegenüberliegend angeordnet ist, zum Erfassen eines Abstandes zwischen dem Abstandssensor (28a, 28b) und einer dem Abstandssensor aktuell zugewandten Reflexionsfläche des Reflexionsabschnitts (20) des Betätigungsknopfes (12) aufweist.

2. Drehbetätigungsvorrichtung nach Anspruch 1, bei welcher der Reflexionsabschnitt (20) des Betätigungsknopfes (12) wenigstens zwei koaxial zueinander angeordnete Teilabschnitte (21a, 21b) mit unterschiedlichen Reflexionseigenschaften aufweist und die Erfassungseinrichtung wenigstens zwei in radialer Richtung des Betätigungsknopfes nebeneinander angeordnete optische Abstandssensoren (28a, 28b) aufweist.

3. Drehbetätigungsvorrichtung nach einem der vorhergehenden Ansprüche, bei welcher
die Erfassungseinrichtung wenigstens zwei optische Abstandssensoren mit einem gemeinsamen Sender aufweist.

4. Drehbetätigungsvorrichtung nach einem der vorhergehenden Ansprüche, bei welcher
der Betätigungsknopf (12) außerdem in einer axialen Richtung bewegbar gelagert ist.

5. Drehbetätigungsvorrichtung nach einem der vorhergehenden Ansprüche, ferner mit
einer Bedienblende (10), an welcher der Betätigungsknopf (12) gelagert ist.

6. Drehbetätigungsvorrichtung nach Anspruch 5, ferner mit
einer Haltevorrichtung (22) zum Halten des Betätigungsknopfes (12) an der Bedienblende (10).

7. Drehbetätigungsvorrichtung nach Anspruch 4 und 6, bei welcher
die Haltevorrichtung (22) den Betätigungsknopf (12) in axialer Richtung in eine axiale Ruhestellung vorspannt.

8. Drehbetätigungsvorrichtung nach einem der vorhergehenden Ansprüche, ferner mit
einer Rasteinrichtung zum Verrasten des Betätigungsknopfes (12) in mehreren vorgegebenen Drehstellungen.

9. Drehbetätigungsvorrichtung nach einem der vorhergehenden Ansprüche, ferner mit
wenigstens einer optischen Anzeigevorrichtung, wobei der Betätigungsknopf (12) bevorzugt relativ zu der wenigstens einen Anzeigevorrichtung bewegbar ist.

10. Drehbetätigungsvorrichtung nach einem der Ansprüche 5 bis 9, bei welcher der Reflexionsabschnitt (20) des Betätigungsknopfes (12) auf einer einem Benutzer der Drehbetätigungsvorrichtung abgewandten Rückseite der Bedienblende (10) positioniert ist.

11. Elektronisches Haushaltsgerät, aufweisend wenigstens eine Drehbetätigungsvorrichtung nach einem der vorhergehenden Ansprüche.

## Claims

1. Rotary actuation device, comprising:
an actuation knob (12) mounted rotatably about a rotation axis (14); and
a detection means for detecting a rotary actuation of the actuation knob (12),
**characterized in that**
the actuation knob (12) has on an end side of the actuation knob (12) a reflection section (20), which has reflection faces with different reflection positions along a circumferential direction (16) of the actuation knob (12); and
the detection means has at least one stationary optical distance sensor (28a, 28b), which is arranged opposite the end side in the axial direction of the actuation knob, for detecting a distance between the distance sensor (28a, 28b) and a reflection face,
currently facing toward the distance sensor, of the reflection section (20) of the actuation knob (12).

2. Rotary actuation device according to Claim 1, wherein the reflection section (20) of the actuation knob (12) has at least two subsections (21a, 21b), arranged coaxially with one another, having different reflection properties, and the detection means has at least two optical distance sensors (28a, 28b) arranged next to one another in the radial direction of the actuation knob.

3. Rotary actuation device according to one of the preceding claims, wherein
the detection means has at least two optical distance sensors with a common emitter.

4. Rotary actuation device according to one of the preceding claims, wherein
the actuation knob (12) is furthermore mounted movably in an axial direction.

5. Rotary actuation device according to one of the preceding claims, furthermore having a control panel (10), on which the actuation knob (12) is mounted.

6. Rotary actuation device according to Claim 5, furthermore having
a holding device (22) for holding the actuation knob (12) on the control panel (10).

7. Rotary actuation device according to Claims 4 and 6,
wherein
the holding device (22) prestresses the actuation knob (12) in the axial direction into a neutral axial position.

8. Rotary actuation device according to one of the preceding claims, furthermore having a latching means for latching the actuation knob (12) in a plurality of predetermined rotational positions.

9. Rotary actuation device according to one of the preceding claims, furthermore having at least one optical display device, the actuation knob (12) preferably being movable relative to the at least one display device.

10. Rotary actuation device according to one of Claims 5 to 9, wherein
the reflection section (20) of the actuation knob (12) is positioned on a rear side of the control panel (10) facing away from a user of the rotary actuation device.

11. Household electronic appliance, having at least one rotary actuation device according to one of the preceding claims.

## Revendications

1. Dispositif d'actionnement rotatif, comprenant :
un bouton d'actionnement (12) monté de manière rotative autour d'un axe de rotation (14) ; et
un appareil de détection pour la détection d'un actionnement rotatif du bouton d'actionnement (12),
**caractérisé en ce que**
le bouton d'actionnement (12) comprend une section de réflexion (20) sur un côté frontal du bouton d'actionnement (12), qui comprend des surfaces de réflexion ayant différentes positions de réflexion le long d'une direction circonférentielle (16) du bouton d'actionnement (12) ; et
l'appareil de détection comprend au moins un capteur de distance optique fixe (28a, 28b), qui est agencé en vis-à-vis du côté frontal dans la direction axiale du bouton d'actionnement, pour la détection d'une distance entre le capteur de distance (28a, 28b) et une surface de réflexion de la section de réflexion (20) du bouton d'actionnement (12) faisant actuellement face au capteur de distance.

2. Dispositif d'actionnement rotatif selon la revendication 1, dans lequel
la section de réflexion (20) du bouton d'actionnement (12) comprend au moins deux sections partielles (21a, 21b) agencées coaxialement l'une de l'autre, ayant des propriétés de réflexion différentes, et l'appareil de détection comprend au moins deux capteurs de distance optiques (28a, 28b) agencés l'un à côté de l'autre dans la direction radiale du bouton d'actionnement.

3. Dispositif d'actionnement rotatif selon l'une quelconque des revendications précédentes, dans lequel l'appareil de détection comprend au moins deux capteurs de distance optiques ayant un émetteur commun.

4. Dispositif d'actionnement rotatif selon l'une quelconque des revendications précédentes, dans lequel le bouton d'actionnement (12) est en outre monté de manière mobile dans une direction axiale.

5. Dispositif d'actionnement rotatif selon l'une quelconque des revendications précédentes, comprenant en outre
un panneau de commande (10), sur lequel est monté le bouton d'actionnement (12).

6. Dispositif d'actionnement rotatif selon la revendication 5, comprenant en outre
un dispositif de retenue (22) pour la retenue du bouton d'actionnement (12) sur le panneau de commande (10).

7. Dispositif d'actionnement rotatif selon les revendications 4 et 6, dans lequel
le dispositif de retenue (22) précontraint le bouton d'actionnement (12) dans la direction axiale dans une position de repos axiale.

8. Dispositif d'actionnement rotatif selon l'une quelconque des revendications précédentes, comprenant en outre
un appareil d'encliquetage pour l'encliquetage du bouton d'actionnement (12) dans plusieurs positions de rotation prédéterminées.

9. Dispositif d'actionnement rotatif selon l'une quelconque des revendications précédentes, comprenant en outre
au moins un dispositif indicateur optique, le bouton d'actionnement (12) étant de préférence mobile par rapport à l'au moins un dispositif indicateur.

10. Dispositif d'actionnement rotatif selon l'une quelconque des revendications 5 à 9, dans lequel la section de réflexion (20) du bouton d'actionnement (12) est positionnée sur un côté arrière du panneau de commande (10) détourné d'un utilisateur du dispositif d'actionnement rotatif.

11. Appareil ménager électronique, comprenant au moins un dispositif d'actionnement rotatif selon l'une quelconque des revendications précédentes.
